# EUROPÄISCHE PATENTANMELDUNG

(11) **EP 3 285 165 A1**
(43) Veröffentlichungstag der Anmeldung: **21.02.2018**
(21) Anmeldenummer: 16184654.8
(22) Anmeldetag: 18.08.2016
(51) Int. Cl.: G06F 9/455

(54) **MODIFIZIEREN UND SIMULIEREN DER BETRIEBSSOFTWARE EINES TECHNISCHEN SYSTEMS**

(71) Anmelder: dSPACE digital signal processing and control engineering GmbH, 33102 Paderborn (DE)
(72) Erfinder: Holler, Dominik, 33189 Schlangen (DE); Amringer, Nicolas, 33189 Schlangen (DE); Leinfellner, Robert, 33098 Paderborn (DE); Kiffmeier, Dr. Ulrich, 33428 Harsewinkel (DE)

(57) **Zusammenfassung**

Erfindungsgemäß wird die Betriebssoftware 10 eines technischen Systems, insbesondere eines Steuergeräts zum Steuern oder Regeln zumindest eines technischen Geräts, modifiziert, indem in der unmittelbar auf dem technischen System ausführbaren Betriebssoftware 10 hardwareabhängige Softwareanteile nicht zur Ausführung kommen und statt dessen das funktionale Verhalten der hardwareabhängigen Softwareanteile durch Ersatzfunktionen 23 nachgebildet wird. Die hardwareabhängigen Softwareanteile werden dazu automatisch identifiziert (Schritt S1), sowie die Ersatzfunktionen 23 automatisch ermittelt oder erzeugt. Die derart modifizierte Betriebssoftware 20 simuliert bei Ausführung auf einer geeigneten Simulationsumgebung 200 (Schritt S3) das technische System unabhängig von dessen realer Hardware 100.

## Beschreibung

Die vorliegende Erfindung betrifft die Modifikation der Betriebssoftware eines technischen Systems sowie eine entsprechend modifizierte Betriebssoftware. Ferner betrifft die Erfindung die Simulation der Betriebssoftware und eine entsprechende Simulationsumgebung. Insbesondere betrifft die Erfindung die Modifikation und Simulation der Betriebssoftware eines Steuergeräts ("Electronic Control Unit", ECU), welches andere technische Geräte steuert oder regelt, zum Beispiel Fahrzeugmotoren oder dergleichen.

Im Rahmen des computergestützten Entwickelns und Testens von technischen Systemen und deren Betriebssoftware wird häufig ein reales, technisches System durch ein virtuelles System nachgebildet und als Softwaremodell auf einer geeigneten Entwicklungs- und Simulationsumgebung simuliert. Mittels eines solches Softwaremodells kann sowohl die Betriebssoftware des technischen Systems als auch dessen Hardware modelliert werden. Die Softwaremodelle von Steuergeräten werden üblicherweise als "Virtuelles Steuergerät" oder "Virtual Electronic Control Unit" (virtual ECU) bezeichnet. Beim Testen eines Steuergeräts wird zum Beispiel die im Quellcode vorliegende Betriebssoftware für eine bestimmte Simulationsumgebung übersetzt (kompiliert), dort simuliert, getestet und gegebenenfalls weiterentwickelt.

Die Simulation eines technischen Systems bzw. Steuergeräts ausgehend von der individuell kompilierten Betriebssoftware ist jedoch häufig problematisch, denn hardwareabhängige technische Effekte, die sich aus dem Zusammenwirken der Betriebssoftware mit der Hardware des technischen Systems ergeben, werden durch die für die Simulationsumgebung übersetzte Betriebssoftware in der Regel nicht ausreichend präzise nachgebildet. Die Folge sind unerwünschte Abweichungen zwischen dem Verhalten des realen Systems und dessen Simulation. Derartige Effekte resultieren beispielsweise aus den individuellen Eigenschaften der betreffenden Mikrocontroller oder Prozessoren und deren spezifischen Befehlssätzen. Mikrocontroller, umfassend mindestens einen Prozessor und zusätzliche Peripherie, sind häufig ein zentraler Bestandteil zu simulierender technischer Systeme, insbesondere im Bereich eingebetteter Systeme, wie z.B. dem der Steuergeräte. Die Peripherie des Mikrocontrollers bereitet weitere Schwierigkeiten, denn auch deren technische Wechselwirkungen mit der Betriebssoftware können nicht ohne weiteres simuliert werden. Ohnehin liegt die Betriebssoftware in der Praxis häufig gar nicht als Quellcode vor, so dass allein aus diesem Grund eine Alternative zu dem geschilderten Simulationsansatz benötigt wird.

Eine aus Kostengründen wenig geeignete Alternative ist das vollständige Entfernen aller hardwareabhängigen Softwareanteile aus der Betriebssoftware und anschließendes Nachbilden der Hardware-Wechselwirkungen mit einer anderen, möglichst standardisierten und ähnlichen Hardware oder durch "Rapid Control Prototyping" (RCP). Dies ist jedoch aufwändig und kostspielig, insbesondere hinsichtlich des korrekten Zusammenwirkens solcher Umgehungslösungen mit der geänderten Betriebssoftware. Andere Ansätze zielen darauf ab, die Ausführung einzelner hardwareabhängiger Funktionen zu umgehen und deren Funktionalität anderweitig bereitzustellen. Auch dieser Ansatz erfordert das manuelle Eingreifen von Entwicklungsingenieuren mit spezialisierten Kenntnissen sowohl der betreffenden Hardware als auch der hardwareabhängigen Softwareanteile der Betriebssoftware. Vollständig automatisierte Ansätze scheitern bisher bereits daran, die hardwareabhängigen Softwareanteile der Betriebssoftware vollständig und korrekt zu identifizieren. Ebenso scheitern auch Lösungen ausgehend von Simulationen oder Emulationen der Hardware bereits aus Gründen des technischen Aufwands und der damit verbundenen Kosten, da die Simulations- bzw. Emulationsumgebungen sehr hohe Anforderungen an die Rechenleistung stellen.

Insofern ist es die Aufgabe der vorliegenden Erfindung, eine einfache und kostengünstige Möglichkeit zu schaffen, die Betriebssoftware eines technischen Systems und deren hardwareabhängige Softwareanteile zu simulieren.

Gelöst wird diese Aufgabe durch ein Verfahren zum Modifizieren einer Betriebssoftware und zum Simulieren eines technischen Systems mit Hilfe einer modifizierten Betriebssoftware, sowie durch eine Simulationsumgebung und eine modifizierte Betriebssoftware gemäß den unabhängigen Ansprüchen. In den davon abhängigen Ansprüchen sind vorteilhafte Ausgestaltungen, Weiterbildungen der Erfindung angegeben.

Erfindungsgemäß werden in einer bereitgestellten Betriebssoftware eines technischen Systems zunächst diejenigen Softwareanteile automatisch identifiziert, deren Ausführung abhängig von der Hardware des betreffenden technischen Systems ist. Die automatische Identifikation betrifft solche Softwareanteile, die mit der Hardware des zu simulierenden technischen Systems interagieren. Für die identifizierten, hardwareabhängigen Softwareanteile werden anschließend spezifische Ersatzfunktionen ermittelt, deren Ausführung keine Interaktion mit der Hardware des technischen Systems erfordert. Die Ersatzfunktionen sind unabhängig von der realen Hardware des technischen Systems und können insofern in einer Simulationsumgebung ausgeführt werden. Die hardwareabhängigen Softwareanteile werden schließlich in der Betriebssoftware durch die betreffenden hardwareunabhängigen Ersatzfunktionen derart ersetzt, dass einerseits die hardwareabhängigen Softwareanteile keine Wirkung mehr entfalten, und die Ersatzfunktionen andererseits die von der Betriebssoftware benötigten technischen Effekte der hardwareabhängigen Softwareanteile möglichst präzise nachbilden. Im Ergebnis wird das technische System durch Ausführung der modifizierten Betriebssoftware auf einer geeigneten Simulationsumgebung unabhängig von dessen Hardware simuliert.

Das Ersetzen der hardwareabhängigen Softwareanteile derart, dass sie in der modifizierten Betriebssoftware keine Wirkung mehr entfalten, kann einerseits dadurch erreicht werden, dass die hardwareabhängigen Softwareanteile vollständig durch die betreffenden Ersatzfunktionen ersetzt werden. In diesem Fall bleiben in der modifizierten Betriebssoftware keine hardwareabhängigen Softwareanteile mehr übrig und die Ersatzfunktionen treten in der modifizierten Betriebssoftware quasi eins-zu-eins an deren Stelle. Andererseits - und bevorzugt - können auch lediglich Aufrufe, aufgerufene Funktionen und/ oder Schnittstellenimplementierungen der hardwareabhängigen Softwareanteile derart geändert werden, dass in der modifizierten Betriebssoftware die Ersatzfunktionen anstelle von Teilen der hardwareabhängigen Softwareanteile aufgerufen werden. Der Binärcode der hardwareabhängigen Softwareanteile verbleibt in diesem Fall zumindest teilweise in der modifizierten Betriebssoftware, während hardwareunabhängige Funktionen die Ersatzfunktionen über die entsprechend geänderten Funktionen, Aufrufe und/ oder Schnittstellenimplementierungen in der modifizierten Betriebssoftware aufrufen.

Die erfindungsgemäße Modifikation der Betriebssoftware findet wenigstens insoweit automatisiert statt, dass die hardwareabhängigen Softwareanteile ohne manuelle Interaktion identifiziert werden. Vorzugsweise werden zudem die hardwareunabhängigen Ersatzfunktionen automatisch erzeugt oder ermittelt und die hardwareabhängigen Softwareanteile automatisch durch die Ersatzfunktionen ersetzt.

Die Betriebssoftware ist unmittelbar auf dem technischen System ausführbar, das heißt sie liegen in einem ausführbaren Binärcode oder dergleichen vor. Die hardwareabhängigen Softwareanteile der Betriebssoftware greifen direkt auf die Hardware des technischen Systems zu, beispielsweise auf den Mikrocontroller eines Steuergeräts und hierbei im Allgemeinen auf die Peripherie des Mikrocontrollers. Insbesondere kann dieser Zugriff in Maschinensprache unter Ausnutzung des Befehlssatzes direkt auf Register der Peripherie des Mikrocontrollers erfolgen.

Vorzugsweise ist die erfindungsgemäß zu modifizierende Betriebssoftware auf einem elektronischen Steuergerät (ECU) installiert, das andere technische Systeme innerhalb eines Fahrzeugs steuert und/oder regelt. Die hardwareabhängigen Softwareanteile der Betriebssoftware interagieren mit einem, auf dem Steuergerät befindlichen Mikrocontroller und dessen Peripherie, sowie gegebenenfalls weiteren Hardwarekomponenten. Die Betriebssoftware umfasst insofern mehrere aufeinander aufbauende Softwareschichten, zum Beispiel eine Anwendungsschicht, eine Dienstschicht ("middleware"), ein Betriebssystem und/oder eine Hardwareabstraktionsschicht. Konkrete Ausprägungen von Dienst- und Hardwareabstraktionsschicht sind die Laufzeitumgebung ("run time environment", RTE) und die hardwareabhängige Basissoftwareschicht ("microcontroler abstraction layer", MCAL) gemäß dem AUTOSAR-Standard. Erfindungsgemäß werden die in der hardwareabhängigen Basissoftwareschicht vorhandenen hardwareabhängigen Softwareanteile durch hardwareunabhängige Ersatzfunktionen ersetzt.

Eine entsprechende Simulationsumgebung umfasst einen Simulator des betreffenden technischen Systems bzw. Steuergeräts, der geeignet ist, die erfindungsgemäß modifizierte Betriebssoftware auszuführen und das technische System bzw. Steuergerät dadurch ohne Zugriff auf dessen Hardware zu simulieren. Gemäß einem erfindungsgemäßen Simulationsverfahren wird das betreffende technische System bzw. Steuergerät durch Ausführen der erfindungsgemäß modifizierten Betriebssoftware auf der Simulationsumgebung simuliert.

Anstelle der hardwareabhängigen Softwareanteile werden in der Simulationsumgebung die funktional äquivalenten Ersatzfunktionen ausgeführt. Diese können entweder als integrale Bestandteile in die modifizierten Betriebssoftware integriert werden oder, bevorzugt, außerhalb der modifizierten Betriebssoftware in einer unmittelbar von der Simulationsumgebung ausführbaren Form vorliegen und Ergebnisse und Rückgabewerte an die jeweils aufrufenden Funktionen innerhalb der modifizierten Betriebssoftware zurückgeben. In diesem Fall liegen die Ersatzfunktionen beispielsweise in einer Funktionsbibliothek mit Ersatzfunktionen oder in ergänzenden Funktionsmodulen mit Ersatzfunktionen vor, die aufgerufen werden, sobald der hardwareunabhängige Anteil der Betriebssoftware die Funktionalität eines hardwareabhängigen Softwareanteils benötigt und diese über die modifizierten Anteile der Betriebssoftware bereitgestellt wird.

Wie bereits angesprochen liegt die Betriebssoftware vorzugsweise als Binärcode vor, der unmittelbar von dem technischen System bzw. dem Mikrocontroller eines Steuergerätes interpretierbar oder ausführbar ist. Die hardwareabhängigen Softwareanteile werden darin vorzugsweise durch Schnittstellenspezifikationen identifiziert, welche zumindest diejenigen Binärschnittstellen spezifizieren, über die die zu ersetzenden hardwareabhängigen Softwareanteile aufgerufen werden. Aus den Schnittstellenspezifikationen sind Binärcodemuster, insbesondere auch automatisch, ableitbar, welche spezifisch für die hardwareabhängigen Softwareanteile des technischen Systems sind und die betreffenden Binärschnittstellen kennzeichnen. Unter Verwendung von Abbildungsvorschriften lassen sich in der zu modifizierenden Betriebssoftware die Implementierungen, der hinter den Binärcodemustern befindlichen hardwareabhängigen Softwareanteile, automatisch auffinden. Die Schnittstellenspezifikationen können proprietär sein, vorzugsweise entsprechen sie jedoch einem einschlägigen Industriestandard, beispielsweise dem AUTOSAR-Standard im Bereich der Automobilindustrie.

Die Schnittstellenspezifikationen werden beim Übersetzen des Quellcodes der Betriebssoftware in den Binärcode zur Erzeugung der Implementierung der Binärschnittstellen genutzt. Auf der Ebene des Quellcodes beschreiben die Schnittstellenspezifikationen Schnittstellen für die Anwendungsprogrammierung, sogenannte Programmierschnittstellen ("application programming interfaces", API), die Zugänge zu den hardwareabhängigen Softwareanteilen bilden. Die Programmierschnittstellen korrespondieren auf der Ebene des Binärcodes mit den Binärschnittstellen zwischen hardwareunabhängigen und hardwareabhängigen Softwareanteilen. Durch Ermitteln der betreffenden Binärcodemuster im Binärcode der Betriebssoftware werden die hardwareabhängigen Softwareanteilen automatisiert identifiziert.

Vorzugsweise ist der Binärcode der Betriebssoftware derart organisiert bzw. wird derart übersetzt, dass er eine separate Schnittstellenschicht umfasst, in der die hardwareabhängigen Softwareanteile der Betriebssoftware vorliegen und die deshalb als einzige Schicht der Betriebssoftware von der Hardware des technischen Systems abhängig ist. Die Schnittstellenschicht umfasst sowohl die Binärschnittstellen, über die hardwareabhängige Softwareanteile aus anderen Schichten der Betriebssoftware heraus aufrufbar sind, als auch die hardwareabhängigen Softwareanteile selbst. Grundlage für das Bereitstellen einer derartigen Schnittstellenschicht kann wiederum ein Standard sein, zum Beispiel der AUTOSAR-Standard.

Beim Schritt des Ersetzens der identifizierten hardwareabhängigen Softwareanteile durch geeignete Ersatzfunktionen wird vorzugsweise nur die Schnittstellenschicht modifiziert, alle anderen Bestandteile der Betriebssoftware können unverändert bleiben. Anstatt der Modifikation einzelner hardwareabhängiger Softwareanteile und/ oder deren Binärschnittstellenimplementierungen kann auch die gesamte Schnittstellenschicht durch eine Ersatzschnittstellenschicht bzw. Ersatzschicht ersetzt werden, die bei Ausführung der modifizierten Betriebssoftware innerhalb der Simulationsumgebung eine Funktionalität bereitstellt, die anstelle der hardwareabhängigen Softwareanteile Funktionsaufrufe der Ersatzfunktionen oder die vollständige Funktionalität der Schnittstellenschicht umfasst.

Zum Ersetzen der hardwareabhängigen Softwareanteile werden solche Ersatzfunktionen ermittelt, die bei Ausführung auf der Simulationsumgebung die Funktionalitäten der hardwareabhängigen Softwareanteile nachbilden. Die entsprechenden Funktionsaufrufe ersetzen in der Ersatzschicht insofern die Aufrufe der hardwareabhängigen Softwareanteile in der Schnittstellenschicht bzw. die betreffenden Binärschnittstellenimplementierungen.

Gemäß einer bevorzugten Ausführungsform der Erfindung werden die Ersatzfunktionen basierend auf den bereits genannten Schnittstellenspezifikationen und/oder Abbildungsvorschriften ermittelt. Letztere repräsentieren im Wesentlichen funktionale Beschreibungen der hardwareabhängigen Softwareanteile und/ oder der betreffenden Binärschnittstellen, die bei der Übersetzung bzw. der Erzeugung des Binärcodes der Betriebssoftware aus dem Quellcode eingesetzt werden. Die Abbildungsvorschriften spezifizieren insofern auch die Funktionalität der Ersatzfunktionen. Die funktionalen Beschreibungen werden verwendet, um die Funktionalitäten der hardwareabhängigen Softwareanteile mittels einer Simulationsumgebung nachzubilden. Dies kann z.B. mit Hilfe eines Befehlssatzsimulators der Simulationsumgebung erfolgen, welcher den Befehlssatz des Prozessors oder Mikrokontrollers des technischen Systems oder Steuergeräts nachbildet.

Die Ersatzfunktionen sind vorzugsweise in Ersatzfunktionsbibliotheken organisiert, die von der eingesetzten Simulationsumgebung unterstützt werden und auf deren Ersatzfunktionen die Funktionsaufrufe in der Ersatzschicht verweisen. Die Modifikation der Betriebssoftware besteht in diesem Falle im Wesentlichen darin, die Ersatzschicht mit Funktionsaufrufen auf geeignete Ersatzfunktionen auszustatten oder die Binärschnittstellenimplementierung mit entsprechenden Funktionsaufrufen zu versehen. Die Ersatzfunktionen liegen deshalb entweder als Binärcode vor, beispielsweise wenn sie in die Ersatzschicht integriert werden, oder in einem anderweitig von der Simulationsumgebung ausführbaren Format.

Weitere Merkmale und Vorteile der Erfindung ergeben sich aus der folgenden Beschreibung erfindungsgemäßer Ausführungsbeispiele sowie weiteren Ausführungsalternativen im Zusammenhang mit den folgenden Zeichnungen, die zeigen:
- Figur 1: ein Flussdiagramm des erfindungsgemäßen Verfahrens;
- Figur 2: den Aufbau einer Betriebssoftware (Fig. 2a) sowie einer erfindungsgemäß modifizierten Betriebssoftware (Fig. 2b); und
- Figur 3: eine weitere Ausführungsform der Erfindung.

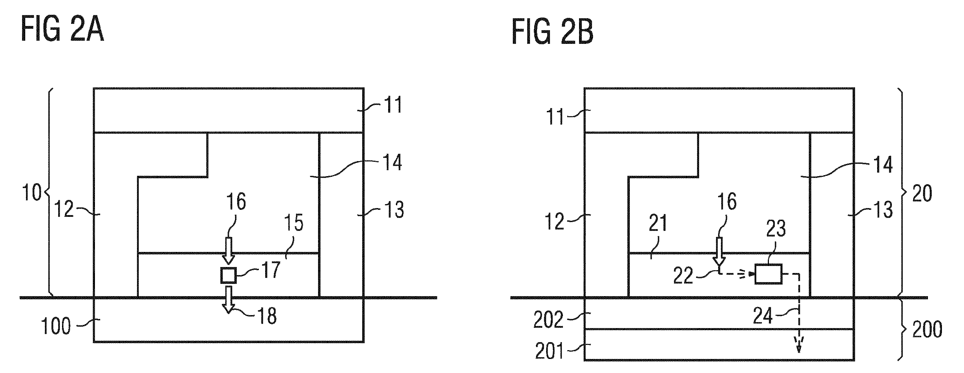

Die Figur 2a zeigt schematisch den Aufbau einer Betriebssoftware 10 eines Steuergeräts (nicht abgebildet), die auf dem Mikrocontroller 100 des Steuergerätes ausführbar ist. Die Betriebssoftware 10 liegt in Form eines Binärcodes vor, beispielsweise in Maschinensprache, und ist auf dem Steuergerät bzw. dessen Mikrocontroller 100 unmittelbar lauffähig.

Die Betriebssoftware 10 umfasst mehrere Komponenten und Schichten, darunter die hardwareabhängige Schicht 15, die den hardwareunabhängigen Anteilen der Betriebssoftware 10 Zugänge zu der Hardware des Steuergeräts bereitstellt, also beispielsweise zur Peripherie des Mikrocontrollers 100. Hardwareunabhängige Anteile der Betriebssoftware 10 liegen insbesondere in der Anwendungsschicht 11, die in der Regel von Anwendungsingenieuren erstellt wird und wesentliche Funktionalitäten der Betriebssoftware bereitstellt. Die Anwendungsschicht 11 interagiert gegebenenfalls über eine geeignete Laufzeitumgebung (nicht dargestellt) mit den darunterliegenden, hardwarenäheren Komponenten und Schichten der Betriebssoftware 10. Im Zusammenhang mit dem AUTOSAR-Standard vermittelt zum Beispiel eine AUTOSAR-Laufzeitumgebung zwischen der Applikationsschicht 11 und den darunter liegenden Standard-konformen Schichten 12,13,14.

Während die Betriebssystemkomponenten 12 und Treiberkomponenten 13 unmittelbaren Zugriff auf den Mikrocontroller 100 besitzen, werden hardwareabhängige Zugriffe aus der Abstraktionsschicht 14 über die Schnittstellenschicht 15 ausgeführt. Die Abstraktionsschicht 14 stellt steuergerätspezifische Funktionalitäten bereit, die auf den Mikrocontroller 100 des Steuergeräts zugreifen, indem über standardisierte Schnittstellen 16 hardwareabhängige Funktionen 17 angesprochen werden, die den eigentlichen Hardwarezugriff 18 auf den Mikrocontroller 100 durchführen. Die Schnittstellen 16 zwischen den hardwareunabhängigen Anteilen der Betriebssoftware 10 in der Abstraktionsschicht 14 und den hardwareabhängigen Anteilen der Betriebssoftware 10 in der Schnittstellenschicht 15 sind Binärschnittstellen ("application binary interfaces", ABI), diese lassen sich mit Hilfe von Spezifikationen ableiten. Diese hard- und/ oder softwarebeschreibenden Spezifikationen können einem Standard entsprechen.

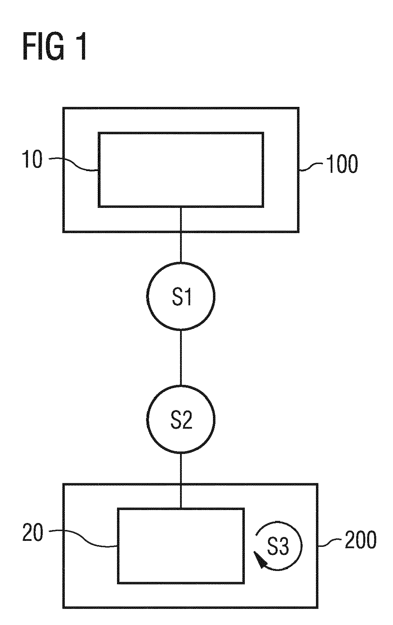

Figur 1 illustriert das erfindungsgemäße Verfahren zur Modifikation der auf den Mikrocontroller 100 des Steuergeräts aufsetzenden Betriebssoftware 10 gemäß Figur 2a durch eine auf einer Simulationsumgebung 200 ausführbaren, modifizierte Betriebssoftware 20, die unabhängig von der Hardware des Steuergeräts und des Mikrocontrollers 100 ist. Hierbei werden zunächst die hardwareabhängigen Softwareanteile bzw. Funktionen 17 der Betriebssoftware 10 ermittelt (Schritt S1) und anschließend durch funktionsäquivalente Ersatzfunktionen 23 derart ersetzt (Schritt S2), dass schließlich die funktionale Verhaltensweise der Betriebssoftware 10 durch Simulieren der modifizierten Betriebssoftware 20 auf der Simulationsumgebung 200 reproduziert werden kann (Schritt S3). Die Schritte S1 und S2 gemäß Figur 1 bewirken den Übergang von der Betriebssoftware 10 gemäß Figur 2a zu der modifizierten Betriebssoftware 20 gemäß Figur 2b.

Figur 2b illustriert die modifizierte Betriebssoftware 20 in der Simulationsumgebung 200. Die Simulationsumgebung 200 besteht unter anderem aus dem eigentlichen Simulator 201, der die erforderlichen Funktionalitäten der hardwareabhängigen Softwareanteile umsetzt, und einem Befehlssatzsimulator 202. Bei der Modifikation der Betriebssoftware 10 entsprechend der Schritte S1 und S2 wird die Schnittstellenschicht 15 mit den hardwareabhängigen Funktionen 17 in eine von der realen Hardware unabhängige Schnittstellenschicht 21 transformiert, deren hardwareunabhängige Ersatzfunktionen 23 die Funktionalität der hardwareabhängigen Funktionen 17 bereitstellen. Die neue, hardwareunabhängige Schnittstellenschicht 21 ersetzt also die ursprüngliche, hardwareabhängige Schnittstellenschicht 15, weshalb erstere im vorliegenden Zusammenhang auch als "Ersatzschnittstellenschicht" oder schlicht "Ersatzschicht" bezeichnet wird. Sämtliche Funktionalitäten der Ersatzschnittstellenschicht 21 und deren technische Effekte sind weitgehend unabhängig von dem Mikrocontroller 100, sowie dessen Peripherie, denn sie interagiert stattdessen mit der Simulationsumgebung 200. Die Abhängigkeit vom Befehlssatz einer bestimmten Prozessor-Architektur oder eines konkreten Prozessors ist bei der Simulation durch die Wahl eines geeigneten Befehlssatzsimulators 202 zu berücksichtigen.

Die auf diese Weise durch die Ersatzfunktionen 23 simulierten Funktionalitäten und Effekte der hardwareabhängigen Funktionen 17 sind transparent für die weiteren hardwareunabhängigen Anteile der modifizierten Betriebssoftware 20, beispielsweise für die Abstraktionsschicht 14, denn Schnittstellen, Übergabeparameter und Rückgabewerte der Ersatzfunktionen 23 sind identisch oder zumindest kompatibel mit denjenigen der entsprechenden hardwareabhängigen Funktionen 17. Insbesondere können die Binärschnittstellen 16 der modifizierten Betriebssoftware 20 gemäß Figur 2b in der gleichen Weise genutzt werden, wie diejenigen der unmodifizierten Betriebssoftware 10 gemäß Figur 2a.

Bei der modifizierten Betriebssoftware 20 werden über die Binärschnittstellen 16 Funktionsaufrufe 22 zur Ausführung gebracht, die auf die Ersatzfunktionen 23 verweisen, die dann Zugriffe 24 auf die Simulationsumgebung 200 durchführen. Insofern bildet die Ersatzschnittstellenschicht 21 das funktionale Verhalten der hardwareabhängigen Schnittstellenschicht 15 derart nach, dass die Hardwarezugriffe 18 der Betriebssoftware 10, auf den Mikrocontroller 100 inklusive dessen Peripherie, durch Simulatorzugriffe 24 auf den Simulator 201 ersetzt werden, so dass das gefordertes funktionales Verhalten der hardwareabhängigen Softwareanteile durch die betreffenden Ersatzfunktionen 23 nachgebildet wird.

Dazu werden gemäß Schritt S1 in der Schnittstellenschicht 15 zunächst die hardwareabhängigen Softwareanteile bzw. Funktionen 17 automatisch, also ohne manuelle Interaktion durch eine Bedienperson lokalisiert, um sie anschließend gemäß Schritt S2 durch funktional äquivalente hardwareunabhängige Ersatzfunktionen 23 zu ersetzen. Die Ersatzfunktionen 23 werden in die Ersatzschnittstellenschicht 21 mittels der Funktionsaufrufe 22 und Simulatorzugriffe 24 derart integriert, dass hardwareunabhängige Funktionen, zum Beispiel aus der Abstraktionsschicht 14, die Funktionalitäten der Ersatzfunktionen 23 unverändert über die Binärschnittstelle 16 in Anspruch nehmen können.

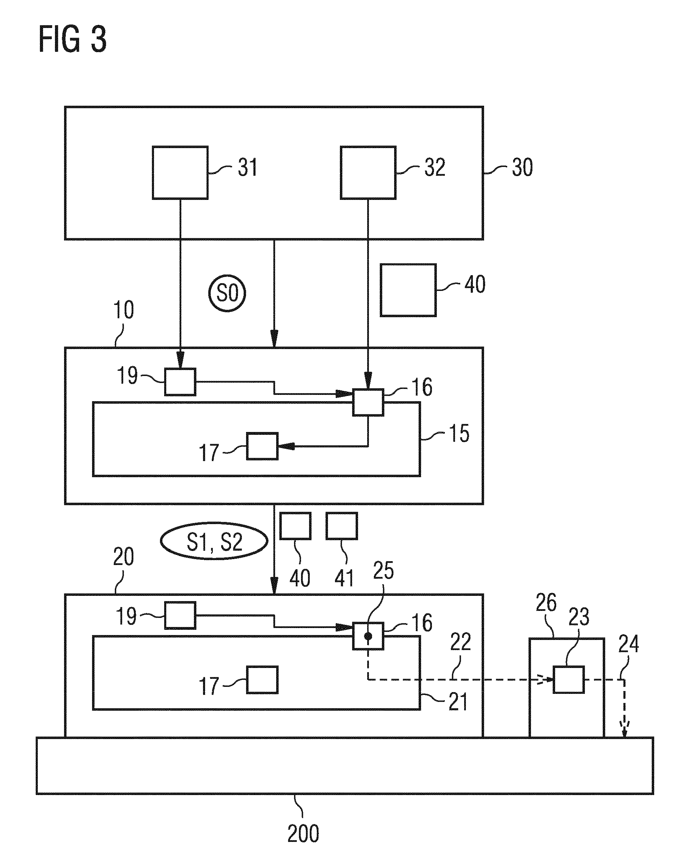

Die hardwareabhängigen Funktionen 17 werden in den Ausführungsbeispielen gemäß Figur 2 anhand von Binärcodemustern identifiziert, die im Binärcode der Betriebssoftware 10 auf die Binärschnittstellen 16 hinweisen bzw. Bestandteile der Implementierung der Binärschnittstellen 16 sind. Die gesuchten Binärcodemuster ergeben sich aus Schnittstellenspezifikationen gemäß dem AUTOSAR- oder anderer einschlägiger Standards, die auf der Quellcode-Ebene Programmierschnittstellen (API) zur Programmierung hardwareabhängiger Funktionen 17 vorgeben mit Hilfe derer die zugehörigen Binärschnittstellen 16 abgeleitet werden können. Im Zusammenhang mit dem Ausführungsbeispiel gemäß Figur 3 wird dies genauer erläutert.

Die Binärcodemuster innerhalb des Binärcodes der Betriebssoftware 10 sind vergleichbar, bezogen auf eine höhere Programmiersprache, mit Funktionssignaturen. Sie werden anhand der Schnittstellenspezifikationen ermittelt, also anhand von formalen Beschreibungen der Binärschnittstellen 16 in der Schnittstellenschicht 15, beispielsweise in Form von UML-Modellen ("Unified Modeling Language") oder dergleichen. Die Binärcodemuster fungieren beim Identifizieren der hardwareabhängigen Softwareanteile (Schritt S1) insofern als Suchmuster eines Pattern-Matching-Prozesses im Binärcode der Betriebssoftware 10. Die Schnittstellenspezifikationen liefern hierbei Hinweise auf den Aufruf von hardwareabhängigen Softwareanteilen 17 im Binärcode über die betreffenden Binärschnittstellen 16. Sofern die Schnittstellenspezifikationen nicht aufgrund eines Standards bekannt sind, können sie auch in Form von manuell erstellten und dann wiederverwendbaren Konfigurationsdateien bereitgestellt werden.

Die hardwareabhängigen Funktionen 17 werden in Schritt S2 durch Ersatzfunktionen 23 ersetzt, indem funktionale Beschreibungen der zu ersetzenden hardwareabhängigen Funktionen 17 herangezogen werden. Mit den funktionalen Beschreibungen werden die funktional äquivalenten Ersatzfunktionen 23 automatisch ermittelt oder erzeugt. Die funktionalen Beschreibungen sind hierbei Bestandteile von Abbildungsvorschriften, die hardwareabhängige Funktionen 17 auf Ersatzfunktionen 23 abbilden. Die Ersatzfunktionen 23 ersetzen dann die hardwareabhängigen Funktionen 17 in der Ersatzschnittstellenschicht 21 oder werden in diese integriert. Im letztgenannten Fall können die hardwareabhängigen Funktionen 17 zwar in der modifizierten Betriebssoftware noch vorhanden sein, werden dort aber nicht mehr aufgerufen, da in der modifizierten Betriebssoftware 20 ein Aufruf über die Binärschnittstelle 16 durch den Funktionsaufruf 22 an die Ersatzfunktion 23 umgelenkt wird.

Die Ausführungsform gemäß Figur 3 veranschaulicht die Erfindung noch einmal ausgehend von dem Zusammenhang zwischen dem Quellcode 30 und Binärcode der Betriebssoftware 10 und der ebenfalls in Form eines ausführbaren Codes vorliegenden modifizierten Betriebssoftware 20. Gemäß Figur 3 wird der Quellcode 30 zunächst in einem den Schritten S1 und S2 vorgeschalteten Schritt S0 in den Binärcode 10 übersetzt (kompiliert). Hierbei wird eine im Quellcode 30 vorliegende hardwareunabhängige Funktion 31, die bei Ausführung über eine bereitgestellte Programmierschnittstelle 32 eine Interaktion mit dem Mikrocontroller 100 anfordert, in eine hardwareunabhängige Binärfunktion 19 übersetzt. Ferner wird in dem Binärcode 10 die Schnittstellenschicht 15 mit der Binärschnittstelle 16 und der hardwareunabhängigen Binärfunktion 17 gebildet.

Die Implementierung der Binärschnittstelle 16 wird hierbei ausgehend von der Programmierschnittstelle 32 und einer AUTOSAR-Schnittstellenspezifikation 40 erzeugt, aus der unter anderem die Ausgestaltung der Binärschnittstelle 16 und der darin enthaltenen Binärcodemuster ableitbar sind, die im Schritt S1 zur Identifikation von hardwareabhängigen Funktionen 17 im Binärcode 10 dienen. Die Schnittstellenspezifikation 40 repräsentiert eine funktionale Beschreibung der Programmierschnittstelle 32, aus der durch den Übersetzungsschritt S0 eine binäre Schnittstellenbeschreibung in Form der Binärschnittstelle 16 und der betreffenden Binärcodemuster erzeugt wird. Daneben spezifiziert die Schnittstellenspezifikation 40 die im Quellcode 30 aufrufbaren Funktionen und gibt an, ob diese hardwareabhängig sind, wie zum Beispiel die hardwareabhängige Funktion 17, oder hardwareunabhängig sind.

Bei der Erzeugung der modifizierten Betriebssoftware 20 wird die Schnittstellenspezifikation 40 verwendet, um die hardwareabhängigen Funktionen 17 im Binärcode der Betriebssoftware 10 entsprechend des Schritts S1 zu identifizieren. Daneben werden gemäß dem Ausführungsbeispiel der Figur 3 auch Abbildungsvorschriften 41 verwendet, zum Beispiel in Form von Abbildungsdateien ("map files"). Die Abbildungsvorschriften 41 werden im Zusammenhang mit dem Schritt S2 eingesetzt, um den identifizierten hardwareabhängigen Funktionen 17 Ersatzfunktionen 23 zuzuordnen, die bei Ausführung in der Simulationsumgebung 200 eine Funktionalität bereitstellen, die äquivalent zu derjenigen Funktionalität ist, die die betreffende hardwareabhängige Funktion 17 in Interaktion mit der Hardware des Mikrocontrollers 100 zur Folge hat.

Die Abbildungsvorschriften 41 umfassen hierzu funktionale Beschreibungen der zu ersetzenden hardwareabhängige Funktion 17, auf deren Basis geeignete Ersatzfunktionen 23 ermittelt oder erzeugt werden. In letzterem Fall wird die Funktionalität der zu ersetzenden hardwareabhängigen Funktion 17 ausgehend von der funktionalen Beschreibung in der Simulationsumgebung 200, gegebenenfalls mit dem Befehlssatzsimulator 202, nachgebildet. Die Abbildungsvorschriften 41 können darüber hinaus auch bei der Identifikation der hardwareabhängigen Funktionen im Binärcode 10 Verwendung finden, denn sie stellen mit der funktionalen Beschreibung auch Zuordnungen von den im Quellcode 30 verwendeten Funktionen zu den im Binärcode vorliegenden hardwareabhängigen Funktionen 17 her.

Anders als bei der Ausführungsform gemäß Figur 2b werden die Ersatzfunktionen 23 bei der Ausführungsform gemäß Figur 3 nicht in die Ersatzschnittstellenschicht 21 integriert, sondern es werden lediglich Funktionszugriffe 22 in die betreffenden Implementierung der Binärschnittstellen 16 integriert, die die vorhandenen hardwareabhängigen Funktionen 17 umgehen und statt dessen auf die Ersatzfunktionen 23 verweisen. Die hardwareabhängigen Binärfunktionen 17 werden funktionslos, denn sie können über die Binärschnittstelle 16 nicht mehr angesprochen werden. Die Ersatzfunktionen 23 liegen außerhalb der Ersatzschnittstellenschicht 21 in einer Funktionsbibliothek 26 vor und interagieren schließlich mit der Simulationsumgebung 200 über die Simulatorzugriffe 24.

Die Implementierungen der Binärschnittstellen 16 werden im Zuge der Ersetzung der hardwareabhängigen Funktionen 17 derart modifiziert, dass sie die Ersatzfunktionen 23 aufrufen, also mit entsprechenden Funktionsaufrufen 22 versehen werden, wobei die Binärschnittstellen 16, insbesondere gegenüber höheren Schichten, unverändert bleiben.

## Patentansprüche

1. Verfahren zum Modifizieren einer Betriebssoftware (10) eines technischen Systems, insbesondere eines Steuergeräts zum Steuern oder Regeln zumindest eines technischen Geräts, umfassend den Schritt des Bereitstellens (S0) der unmittelbar auf dem technischen System ausführbaren Betriebssoftware (10), **gekennzeichnet durch** die weiteren Schritte:
- automatisches Identifizieren (S1) von Softwareanteilen (17) der Betriebssoftware (10), deren Ausführung abhängig von der Hardware (100) des technischen Systems ist; und
- Ersetzen (S2) der identifizierten, hardwareabhängigen Softwareanteile (17) **durch** Ersatzfunktionen (23), deren Ausführung unabhängig von der Hardware (100) des technischen Systems ist,
wobei die derart modifizierte Betriebssoftware (20) das technische System bei Ausführung auf einer Simulationsumgebung (200) unabhängig von der Hardware (100) des technischen Systems simuliert (S3).

2. Verfahren nach Anspruch 1, **dadurch gekennzeichnet, dass** die Betriebssoftware (10) in Form eines auf dem technischen System ausführbaren Binärcode bereitgestellt wird und die hardwareabhängigen Softwarenanteile (17) in dem Binärcode der Betriebssoftware (10) unter Verwendung von Schnittstellenspezifikationen (40) identifiziert werden (S1).

3. Verfahren nach Anspruch 2, **dadurch gekennzeichnet, dass** die Schnittstellenspezifikationen (40) Binärcodemuster spezifizieren, die spezifisch für die Hardware (100) des technischen Systems sind.

4. Verfahren nach Anspruch 3, **dadurch gekennzeichnet, dass** beim Übersetzen (S0) eines Quellcodes der Betriebssoftware (10) in den Binärcode mittels der Schnittstellenspezifikationen (40) Implementierungen von Binärschnittstellen (16) erzeugt werden, die Zugänge zu den hardwareabhängigen Softwareanteilen (17) in der Betriebssoftware (10) bilden, und die Binärcodemuster aus den Binärschnittstellen (16) und/oder den Implementierungen der der Binärschnittstellen (16) abgeleitet werden.

5. Verfahren nach einem der Ansprüche 1 bis 4, **dadurch gekennzeichnet, dass** die Betriebssoftware (10) eine von der Hardware (100) des technischen Systems abhängigen Schnittstellenschicht (15) umfasst, die Zugänge (16) zu den hardwareabhängigen Softwareanteilen (17) in der Betriebssoftware (10) bilden, wobei die hardwareabhängige Schnittstellenschicht (15) durch eine Ersatzschnittstellenschicht (21) ersetzt wird, die Funktionsaufrufe (22) der Ersatzfunktionen (23) umfasst.

6. Verfahren nach Anspruch 5, **dadurch gekennzeichnet, dass** die Ersatzfunktionen (23) automatisch derart ermittelt werden, dass beim Ausführen der Ersatzfunktionen (23) auf der Simulationsumgebung (200) eine Funktionalität der hardwareabhängigen Softwareanteile (17) simuliert wird, und die Ersatzschnittstellenschicht (15) mit Funktionsaufrufen (22) zum Ausführen der ermittelten Ersatzfunktionen (23) ausgestattet wird.

7. Verfahren nach Anspruch 5 oder 6, **dadurch gekennzeichnet, dass** die Ersatzfunktionen (23) unter Verwendung von Abbildungsvorschriften (41) ermittelt und den hardwareabhängigen Softwareanteilen (17) derart zuordnet werden, dass beim Ausführen der Ersatzfunktionen (23) auf der Simulationsumgebung (200) eine Funktionalität der hardwareabhängigen Softwareanteile (17) simuliert wird, und die Ersatzschnittstellenschicht (21) mit Funktionsaufrufen (22) zum Ausführen der ermittelten Ersatzfunktionen (23) ausgestattet wird.

8. Verfahren nach Anspruch 7, **dadurch gekennzeichnet, dass** beim Ermitteln der Ersatzfunktionen (23) unter Verwendung der Abbildungsvorschriften (41) eine funktional Beschreibung der hardwareabhängigen Softwareanteile (17) berücksichtigt wird, mit der eine Funktionalität der hardwareabhängigen Softwareanteile (17) mittels eines Befehlssatzsimulators (202) der Simulationsumgebung (200) nachgebildet wird, der den Befehlssatz eines Prozessors (100) des technischen Systems simuliert.

9. Verfahren nach einem der Ansprüche 5 bis 8 und Anspruch 4, **dadurch gekennzeichnet, dass** die Ersatzschnittstellenschicht (21) die Implementierung der Binärschnittstellen (16) umfasst und die Funktionsaufrufe (22) derart in die Implementierung der Binärschnittstellen (16) integriert werden, dass die außerhalb der Ersatzschnittstellenschicht (21) liegenden Softwareanteile (14) der Betriebssoftware (10, 20) die Ersatzfunktionen (23), insbesondere mittels der Ersatzschnittstellenschicht (21), aufrufen können.

10. Verfahren nach einem der Ansprüche 2 bis 9, **dadurch gekennzeichnet, dass** die Schnittstellenspezifikationen (40) und/ oder die Schnittstellenschicht (15) einem Standard entsprechen, vorzugsweise dem AUTOSAR-Standard.

11. Verfahren nach einem der Ansprüche 1 bis 10, **dadurch gekennzeichnet, dass** die hardwareabhängigen Softwareanteile (17) durch Ersatzfunktionen (23) ersetzt werden, die außerhalb der Betriebssoftware (10, 20) liegen und von der Simulationsumgebung (200), unabhängig von der Betriebssoftware (10), ausgeführt werden (S3).

12. Verfahren nach einem der Ansprüche 1 bis 11, **dadurch gekennzeichnet, dass** die hardwareabhängigen Softwarenanteile (17) durch Ersatzfunktionen (23) in Form von Binärcode und/ oder in Form eines von der Simulationsumgebung (200) ausführbaren Codes ersetzt werden.

13. Verfahren zum Simulieren eines technischen Systems auf einer Simulationsumgebung (200), insbesondere eines Steuergeräts zum Steuern oder Regeln zumindest eines technischen Geräts, wobei die Betriebssoftware (10) des technischen Systems nach einem Verfahren gemäß der Ansprüche 1 bis 12 modifiziert wird (S1, S2) und die modifizierte Betriebssoftware (20) derart auf der Simulationsumgebung (200) ausgeführt wird (S3), dass das technische System simuliert wird.

14. Simulationsumgebung (200), umfassend einen Simulator (202) eines technisches Systems, insbesondere eines Steuergeräts zum Steuern oder Regeln zumindest eines technischen Geräts, wobei der Simulator (202) ausgestaltet und eingerichtet ist, eine nach einem Verfahren gemäß einem der Ansprüche 1 bis 12 modifizierte Betriebssoftware (20) des technischen Systems derart auszuführen, dass das technische System simuliert wird.

15. Modifizierte Betriebssoftware (20) eines technisches Systems, insbesondere eines Steuergeräts zum Steuern oder Regeln zumindest eines technischen Geräts, die nach einem Verfahren gemäß den Ansprüche 1 bis 12 derart modifiziert ist, dass sie bei Ausführung auf der Simulationsumgebung (200) das technische System simuliert.
